# EUROPEAN PATENT APPLICATION

(11) **EP 3 617 760 A1**
(43) Date of publication of application: **04.03.2020**
(21) Application number: 18791488.2
(22) Date of filing: 01.05.2018
(51) Int. Cl.: G02B 6/28, G02B 6/26, G02B 6/42, H01S 5/022

(54) **COMBINER AND LASER DEVICE**

(30) Priority: 28.04.2017 JP 2017089538
(71) Applicant: Fujikura Ltd., Tokyo 135-8512 (JP)
(72) Inventor: MATSUMOTO, Ryokichi, Sakura-shi, Chiba 285-8550 (JP)
(74) Representative: Plasseraud IP
(86) International application number: PCT/JP2018/017450
(87) International publication number: WO 2018/199339

(57) **Abstract**

The present invention provides a combiner superior in low-loss property and reliability to conventional combiners. A combiner (1) includes an input fiber bundle (11), a bridge fiber (13), and an output fiber (14). The bridge fiber (13) includes a GI fiber section (131) which converges a beam bundle emitted from the input fiber bundle (11).

## Description

### Technical Field

The present invention relates to a combiner for combining light beams outputted from respective ones of a plurality of light sources. The present invention also relates to a laser device including the combiner.

### Background Art

A combiner is widely used as an optical component for obtaining high-power laser light by combining a plurality of laser light beams. For example, in a fiber laser including a plurality of laser diodes, a combiner (pump combiner) is used to combine laser light beams outputted from the respective laser diodes. In this case, combined light obtained by the combiner is inputted to a fiber resonator as excitation light. In a fiber laser system including a plurality of fiber lasers, a combiner (output combiner) is used to combine laser light beams outputted from the respective fiber lasers. In this case, combined light obtained by the combiner is applied to an object to be processed as output light.

The output combiner of the fiber laser system combines high-power laser light. In order to minimize heat generation, therefore, the output combiner is required to exhibit low optical loss. The combined light obtained by the output combiner is also required to have a small divergence angle, a good beam profile, and the like.

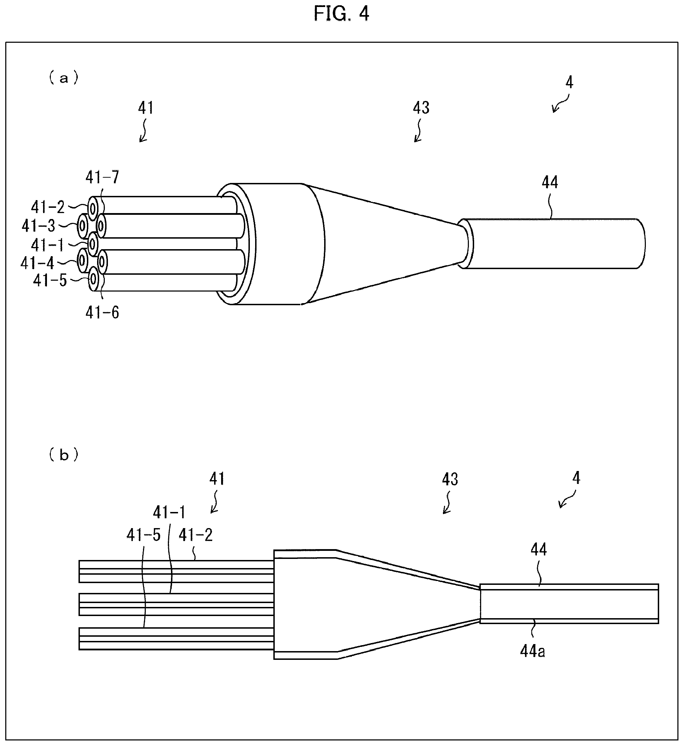

A conventional combiner 4 which is used as an output combiner for fiber laser systems is illustrated in Fig. 4. In Fig. 4, (a) is a perspective view of the combiner 4 and (b) is a cross-sectional view of the combiner 4. The combiner 4 includes an input fiber bundle 41 consisting of a plurality of input fibers 41-1 through 41-7, a bridge fiber 43, and an output fiber 44. Laser light beams inputted to the combiner 4 via the input fiber bundle 41 are combined in the bridge fiber 43 and outputted to an outside via the output fiber 44.

It is necessary that a core diameter of the bridge fiber 43 at an exit end surface thereof, to which the output fiber 44 is connected, be smaller than a core diameter of the bridge fiber 43 at an entrance end surface thereof, to which the input fiber bundle 41 is connected. As such, the bridge fiber 43 includes a reduced diameter part in which the core diameter gradually decreases toward the exit end surface. The larger a diameter reduction ratio of the bridge fiber 43 = (core diameter at the entrance end surface)/(core diameter at the exit end surface), the larger a power density of the combined light entering the output fiber 44 from the bridge fiber 43. Increasing the diameter reduction ratio thus makes it possible to provide a fiber laser system having higher processability.

However, the beam that has entered the bridge fiber 43 from each input fiber bundle of the input fiber bundle 41 is reflected by a core-cladding boundary of the bridge fiber 43 while propagating the reduced diameter part of the bridge fiber 43. This increases a propagation angle of the beam. At this time, the greater the diameter reduction ratio of the bridge fiber 43, the greater a degree of increase of the propagation angle. Thus, the greater the diameter reduction ratio of the bridge fiber 43, the more high numerical aperture (NA) components included in the combined light entering the output fiber 44 from the bridge fiber 43. Of the combined light entering the output fiber 44 from the bridge fiber 43, a component having a NA exceeding a NA of the output fiber 44 cannot be confined to a core 44a of the output fiber 44. Thus, the component leaks out of the core 44a of the output fiber 44 so as to cause a coating of the output fiber 44 and the like to generate heat. As a result, a low-loss property and reliability of the combiner 4 are impaired.

As a combiner developed to solve such a problem, an optical fiber combiner (hereinafter referred to as "combiner 5") disclosed in Patent Literature 1 is known. The combiner 5 disclosed in Patent Literature 1 is illustrated in Fig. 5. In Fig. 5, (a) is a perspective view of the combiner 5 and (b) is a cross-sectional view of the combiner 5. The combiner 5 includes an input fiber bundle 51 consisting of a plurality of input fibers 51-1 through 51-7, a GI fiber bundle 52 consisting of a plurality of graded index (GI) fibers 52-1 through 52-7, a bridge fiber 53, and an output fiber 54. The combiner 5 differs from the conventional combiner 4 in that a GI fiber is inserted between each input fiber of the input fiber bundle 51 and the bridge fiber 53. The GI fiber functions as a GRIN lens for reducing a divergence angle of a beam that has entered the GI fiber from the input fiber. This allows high NA components in combined light entering the output fiber 54 from the bridge fiber 53 to be reduced without a decrease in power density of the combined light entering the output fiber 54 from the bridge fiber 53.

### Citation List

### Patent Literature

Patent Literature 1
Japanese Patent Application Publication *Tokukai* No. 2013-190714

### Summary of Invention

### Technical Problem

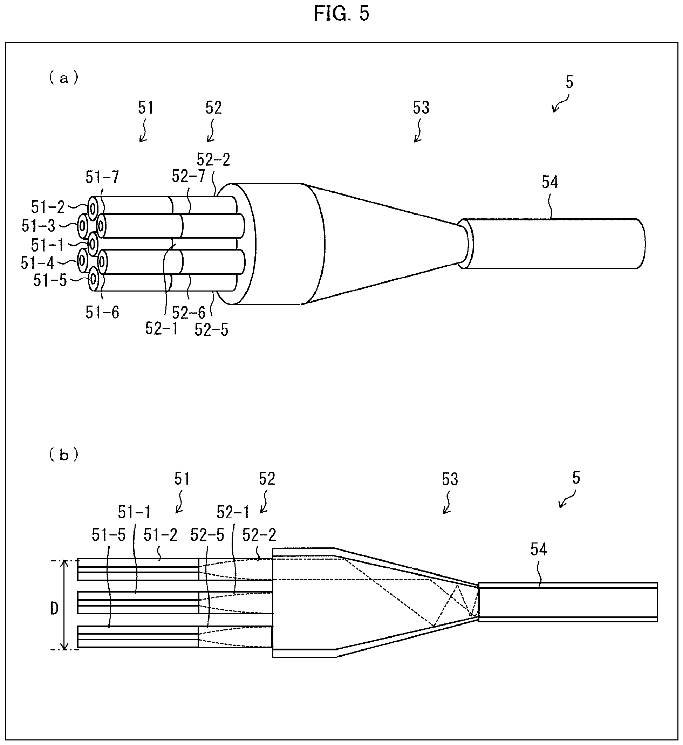

However, also in the combiner 5 described in Patent Literature 1, the propagation angle of the beam that has entered the bridge fiber 53 from each GI fiber of the GI fiber bundle 52 is increased while the beam propagates the reduced diameter part of the bridge fiber 53. In particular, a beam that has entered the bridge fiber 53 from each of the GI fibers 52-2 through 52-7 (the GI fibers 52-2 through 52-7 which are disposed around the GI fiber 52-1 disposed in a center part) disposed in a peripheral part among the GI fibers 52-1 through 52-7 of the GI fiber bundle 52 is repeatedly reflected at the core-cladding boundary of the bridge fiber 53, as illustrated in Fig. 5. This is a factor that increases high NA components in combined light entering the output fiber 54 from the bridge fiber 53. As described above, increase of the high NA components in the combined light entering the output fiber 54 from the bridge fiber 53 impairs the low-loss property and reliability of the combiner 5.

The present invention has been made in view of the above-mentioned problems, and an object of the present invention is to provide a combiner which is superior in low-loss property and reliability to conventional combiners.

### Solution to Problem

In order to attain the object, a combiner in accordance with an aspect of the present invention is a combiner, including: an input fiber bundle consisting of a plurality of input fibers; and a bridge fiber including a GI fiber section which a beam bundle emitted from the input fiber bundle enters, the bridge fiber having a diameter which is smaller at an exit end surface of the bridge fiber than at an entrance end surface of the bridge fiber, the GI fiber section converging the beam bundle emitted from the input fiber bundle.

### Advantageous Effects of Invention

According to an aspect of the present invention, combined light entering an output fiber from a bridge fiber is less likely to have a high NA component than in a conventional combiner. This makes it possible to provide a combiner superior in low-loss property and reliability to conventional combiners.

### Brief Description of Drawings

Fig. 1 is a view illustrating a configuration of a combiner in accordance with Embodiment 1 of the present invention. (a) of Fig. 1 is a perspective view of the combiner and (b) of Fig. 1 is a cross-sectional view of the combiner.
Fig. 2 is a view illustrating a configuration of a combiner in accordance with Embodiment 2 of the present invention. (a) of Fig. 2 is a perspective view of the combiner and (b) of Fig. 2 is a cross-sectional view of the combiner.
Fig. 3 is a view illustrating an example of use of the combiner illustrated in Fig. 1 or Fig. 2. (a) of Fig. 3 is a block diagram of a fiber laser including the combiner as a pump combiner. (b) of Fig. 3 is a block diagram of a fiber laser system including the combiner as an output combiner.
Fig. 4 is a view illustrating a configuration of a conventional combiner. (a) of Fig. 4 is a perspective view of the combiner and (b) of Fig. 4 is a cross-sectional view of the combiner.
Fig. 5 is a view illustrating a configuration of a conventional combiner. (a) of Fig. 5 is a perspective view of the combiner and (b) of Fig. 5 is a cross-sectional view of the combiner.

### Description of Embodiments

Embodiments of the present invention will be described below with reference to drawings. In the following description, a GI fiber refers to a graded index (GI) type optical fiber, and a SI fiber refers to a step index (SI) type optical fiber.

### Embodiment 1

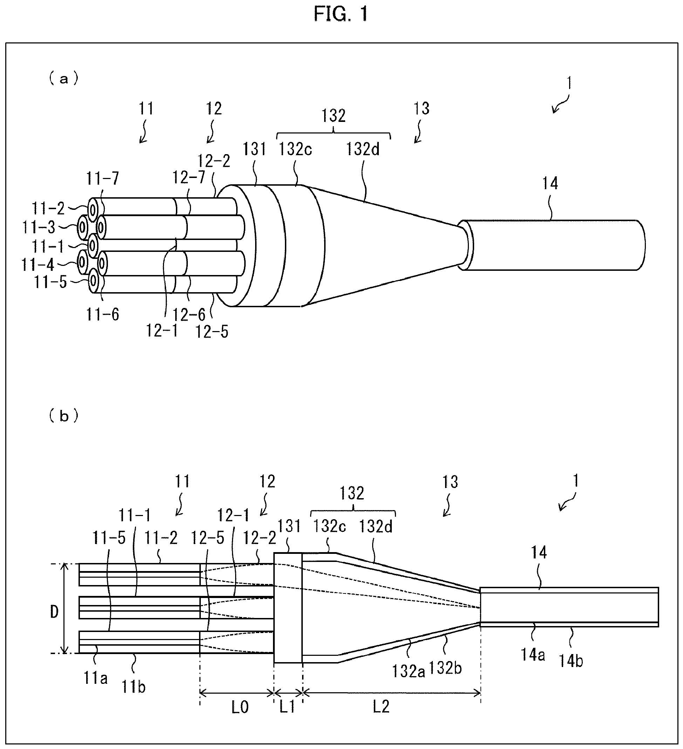

The following description will discuss, with reference to Fig. 1, a configuration of a combiner 1 in accordance with Embodiment 1 of the present invention. In Fig. 1, (a) is a perspective view of the combiner 1 and (b) is a cross-sectional view of the combiner 1.

The combiner 1 is an optical component for generating combined light by combining light beams outputted from respective ones of a plurality of light sources (not illustrated). As illustrated in Fig. 1, the combiner 1 includes an input fiber bundle 11, a GI fiber bundle 12, a bridge fiber 13, and an output fiber 14.

The input fiber bundle 11 consists of a plurality of input fibers 11-1 through 11-n (n is a natural number of 2 or more). Specifically, in Embodiment 1, the input fiber bundle 11 consists of one input fiber 11-1 and six input fibers 11-2 through 11-7 that are disposed so as to surround the input fiber 11-1. Each input fiber 11-i (i = 1 to 7) is a SI fiber and includes a core 11a which is in the shape of a circular rod and a cladding 11b which is in the shape of a circular tube and covers an outer circumferential surface of the core 11a. The core 11a and the cladding 11b are each composed mainly of quartz glass. A refractive index difference between the core 11a and the cladding 11b is provided by one or both of an updopant (a dopant for increasing a refractive index) with which the core 11a is doped and a downdopant (a dopant for decreasing a refractive index) with which the cladding 11b is doped.

Each input fiber 11-i may further include a resin coating (not illustrated) which is in the shape of a circular tube and covers an outer circumferential surface of the cladding 11b. Note, however, that in the vicinity of an exit end surface of each input fiber 11-i, the resin coating is removed so as to expose the outer circumferential surface of a cladding 11-ib, as illustrated in Fig. 1. This is for the purpose of fusion-splicing the exit end surface of each input fiber 11-i to an entrance end surface of a corresponding GI fiber 12-i.

The GI fiber bundle 12 consists of a plurality of GI fibers 12-1 through 12-n. Specifically, in Embodiment 1, the GI fiber bundle 12 consists of one GI fiber 12-1 and six GI fibers 12-2 through 12-7 that are disposed so as to surround the GI fiber 12-1. Each GI fiber 12-i (i = 1 to 7) is in the shape of a circular rod whose diameter is equal to a diameter of a corresponding input fiber 11-i. The entrance end surface of the GI fiber 12-i is connected (e.g., fusion-spliced) to an exit end surface of the corresponding input fiber 11-i. For example, an entrance end surface of the GI fiber 12-1 is connected to an exit end surface of the corresponding input fiber 11-1. Each GI fiber 12-i functions as a GRIN lens for reducing a divergence angle of a beam that has entered the GI fiber 12-i from a corresponding input fiber 11-i. Note that in order for each GI fiber 12-i to function as a GRIN lens for reducing a divergence angle of a beam that has entered the GI fiber 12-i, a length L0 of the GI fiber 12-i may be set to a value other than m×P0/2 (m is any integer of 1 or more) so that, supposing that the beam is a standing wave, an exit end of the GI fiber 12-i is not located at a "node" of the beam having a "node" at an entrance end of the GI fiber 12-i. PO is a pitch length (a beam diameter fluctuation cycle × 2) of the GI fiber 12-i.

The bridge fiber 13 includes a GI fiber section 131 and a SI fiber section 132. The GI fiber section 131 is in the shape of a circular rod whose diameter is larger than a diameter D of a circumscribed circle of the exit end surfaces of the GI fibers 12-1 through 12-7. To an entrance end surface of the GI fiber section 131, exit end surfaces of the GI fibers 12-1 through 12-7 are connected (e.g., fusion-spliced). The GI fiber section 131 functions as a GRIN lens for converging a beam bundle that has entered the GI fiber section 131 from the GI fiber bundle 12. Note that in order for the GI fiber section 131 to function as a GRIN lens for converging a beam bundle that has entered the GI fiber section 131 (for increasing a divergence angle of a beam that has entered the GI fiber section 131), a length L1 of the GI fiber section 131 may be set to a value satisfying m×P1/2 < L1 < m×P1/2+P1/4 (m is any natural number of 0 or more) so that the beam bundle which is a parallel bundle at an entrance end of the GI fiber section 131 becomes a convergent bundle at an exit end of the GI fiber section 131 (in other words, so that, supposing that the beam is a standing wave, the exit end is located in a section between an "antinode" and a "node" of the beam having an "antinode" at the entrance end). P1 is a pitch length of the GI fiber section 131.

The SI fiber section 132 is a SI fiber whose diameter at an entrance end surface thereof is equal to the diameter of the GI fiber section 131 and whose diameter at an exit end surface thereof is smaller than the diameter of the GI fiber section 131. The SI fiber section 132 includes a core 132a having a circular cross section and a cladding 132b having an annular cross section and covering an outer circumferential surface of the core 132a. The core 132a and the cladding 132b are each composed mainly of quartz glass. A refractive index difference between the core 132a and the cladding 132b is provided by an updopant with which the core 132a is doped or by a downdopant with which the cladding 132b is doped. Of the SI fiber section 132, a section 132c including the entrance end surface is in the shape of a circular rod in which a core diameter and a cladding diameter are constant. Of the SI fiber section 132, a section 132d including the exit end surface is in the shape of a truncated cone in which a core diameter and a cladding diameter gradually decrease toward the exit end surface. The section 132d may be referred to as a "reduced diameter part". The entrance end surface of the SI fiber section 132 is connected (e.g., fusion-spliced) to an exit end surface of the GI fiber section 131. Note that the cladding 132b may be omitted. In this case, the air surrounding the outer circumferential surface of the core 132a serves as a cladding (air cladding).

The output fiber 14 is a SI fiber and includes a core 14a which is in the shape of a circular rod and a cladding 14b which is in the shape of a circular tube and covers an outer circumferential surface of the core 14a. The core 14a and the cladding 14b are each composed mainly of quartz glass. A refractive index difference between the core 14a and the cladding 14b is provided by an updopant with which the core 14a is doped or by a downdopant with which the cladding 14b is doped. The output fiber 14 has a core diameter equal to a core diameter of the bridge fiber 13 at an exit end surface of the bridge fiber 13. A portion of the core 14a which portion is at the entrance end surface of the output fiber 14 is connected (e.g., fusion-spliced) to a portion of the core 132a which portion is at the exit end surface of the bridge fiber 13. The cladding 14b at the entrance end surface of the output fiber 14 is connected (e.g., fusion-spliced) to the cladding 132b at the exit end surface of the bridge fiber 13.

Note that the output fiber 14 may further include a resin coating (not illustrated) which is in the shape of a circular tube and covers an outer circumferential surface of the cladding 14b. Note, however, that in the vicinity of the entrance end surface of the output fiber 14, the resin coating is removed so as to expose an outer circumferential surface of the cladding 14b, as illustrated in Fig. 1. This is for the purpose of fusion-splicing the entrance end surface of the output fiber 14 to the exit end surface of the corresponding bridge fiber 13.

As described above, the combiner 1 in accordance with Embodiment 1 is arranged such that the bridge fiber 13 includes the GI fiber section 131 which converges a beam bundle that has entered the bridge fiber 13 from the GI fiber bundle 12. The GI fiber section 131 has such a property that a refractive index of the GI fiber section 131 increases toward an inner side of the GI fiber section 131 and decreases towards an outer side of the GI fiber section 131. The GI fiber section 131 also has such a property that a refractive index change rate (slope) in a direction from the inner side to the outer side of the GI fiber section 131 increases toward the outer side of the GI fiber section 131. Accordingly, a beam is bent with respect to a propagation direction of the beam in such a manner that an extent to which the beam is bent decreases toward the inner side of the GI fiber section 131 and increases toward the outer side of the GI fiber section 131. As a result, a plurality of beams constituting the beam bundle propagate as follows after entering the GI fiber section 131. That is, a beam that has entered the bridge fiber 13 from each of the GI fibers 12-2 through 12-7 disposed in a peripheral part among the GI fibers 12-1 through 12-7 of the GI fiber bundle 12 is bent, to a relatively great extent, in the GI fiber section 131 with respect to a propagation direction of the beam toward the inner side of the bridge fiber 13. Then, the beam propagates linearly toward the entrance end surface of the output fiber 14. Further, a beam that has entered the bridge fiber 13 from the GI fiber 12-1 disposed in a center part among the GI fibers 12-1 through 12-7 of the GI fiber bundle 12 (i) is bent, to a relatively small extent, in the GI fiber section 131 with respect to a propagation direction of the beam toward the inner side of the bridge fiber 13 or (ii) propagates linearly in the GI fiber section 131. Then, the beam propagates linearly toward the entrance end surface of the output fiber 14. Thus, due to this light refraction effect in the GI fiber section 131, the plurality of beams constituting the beam bundle are more likely to propagate linearly, after exiting the GI fiber section 131, toward the entrance end surface of the output fiber 14 so as not to reach the core-cladding boundary of the bridge fiber 13. Accordingly, the plurality of beams are less likely to be reflected by the core-cladding boundary of the bridge fiber 13, and propagation angles of the plurality of beams constituting the beam bundle are less likely to be increased while the plurality of beams propagate the bridge fiber 13. This makes it less likely that combined light entering the output fiber 14 from the bridge fiber 13 includes a high NA component. That is, according to Embodiment 1, it is possible to provide the combiner 1 which is superior in low-loss property and reliability as compared with a case in which the bridge fiber 13 does not include the GI fiber section 131.

In the combiner 1 in accordance with Embodiment 1, it is preferable that a beam bundle be converged by the GI fiber section 131 of the bridge fiber 13 so that a plurality of beams that have entered the bridge fiber 13 from the GI fiber bundle 12 intersect with one another at a center of the exit end surface of the bridge fiber 13. This makes it less likely that the plurality of beams constituting the beam bundle are reflected by the core-cladding boundary of the bridge fiber 13. As a result, propagation angles of the plurality of beams constituting the beam bundle are even less likely to be increased while the plurality of beams propagate the bridge fiber 13. This makes it even less likely that combined light entering the output fiber 14 from the bridge fiber 13 includes a high NA component.

In order for a beam bundle to be converged so that a plurality of beams that have entered the bridge fiber 13 from the GI fiber bundle 12 intersect with one another at the center of the exit end surface of the bridge fiber 13, the length L1 of the GI fiber section 131 and a length L2 of the SI fiber section 132 may be set so as to satisfy the relational expression L2 = 1/(n·g·tan(g·L1)). Note that n is a relative refractive index of a center part of the GI fiber section 131 with respect to that of a center part of the SI fiber section 132, and g is a gradient coefficient of the GI fiber section 131. The gradient coefficient g of the GI fiber section 131 is defined by g = 2π/P1 using the pitch length P1 of the GI fiber section 131. Note that n can be set to n ≈ 1, in which case the above relational expression can be simplified to L2 = 1/(g·tan(g·L1)). For example, in a case where P1 = 40 mm, g = 0.157. In this case, the simplified relational expression is satisfied by setting L1 and L2 to L1 = 2 mm and L2 = 19.6 mm. That is, it is possible to cause a beam bundle to be converged so that a plurality of beams that have entered the bridge fiber 13 from the GI fiber bundle 12 intersect with one another at the center of the exit end surface of the bridge fiber 13.

Note that a similar effect can be attained by employing any of the following configurations (1) to (3) in place of the configuration in which a beam bundle is converged so that a plurality of beams that have entered the bridge fiber 13 from the GI fiber bundle 12 intersect with one another at the center of the exit end surface of the bridge fiber 13. (1) A configuration in which a beam bundle is converged so that a plurality of beams that have entered the bridge fiber 13 from the GI fiber bundle 12 intersect with one another in the vicinity of the center of the exit end surface of the bridge fiber 13. (2) A configuration in which a beam bundle is converged so that a plurality of beams that have entered the bridge fiber 13 from the GI fiber bundle 12 intersect with one another at a center of the entrance end surface of the output fiber 14. (3) A configuration in which a beam bundle is converged so that a plurality of beams that have entered the bridge fiber 13 from the GI fiber bundle 12 intersect with one another in the vicinity of the center of the entrance end surface of the output fiber 14. Note that "the vicinity of the center of the exit end surface of the bridge fiber 13" refers to a set of points at each of which a distance from the center is (i) sufficiently smaller (e.g., 1/10 or less) than a radius of the entrance end surface of the bridge fiber 13 (or of a portion of the bridge fiber 13 which portion has the largest diameter) with respect to a radial direction of the bridge fiber 13 and (ii) sufficiently smaller (e.g., 1/10 or less) than the length L2 of the SI fiber section 132 of the bridge fiber 13 with respect to an axial direction of the bridge fiber 13. Further, "the vicinity of the center of the entrance end surface of the output fiber 14" refers to a set of points each of which is on the entrance end surface of the output fiber 14 and at each of which a distance from the center of the entrance end surface is sufficiently smaller (e.g., 1/10 of less) than a radius of the entrance end surface.

Further, in the combiner 1 in accordance with Embodiment 1, the GI fiber 12-i for reducing a divergence angle of a beam that has entered the GI fiber 12-i from each input fiber 11-i is interposed between the input fiber 11-i and the bridge fiber 13. This makes it less likely that a beam bundle that has entered the bridge fiber 13 from the GI fiber bundle 12 spreads while propagating the bridge fiber 13. As a result, a plurality of beams constituting the beam bundle are even less likely to be reflected by the core-cladding boundary of the bridge fiber 13, and propagation angles of the plurality of beams constituting the beam bundle are even less likely to be increased while the plurality of beams propagate the bridge fiber 13. This makes it even less likely that combined light entering the output fiber 14 from the bridge fiber 13 includes a high NA component.

In the combiner 1 in accordance with Embodiment 1, it is preferable that the GI fiber 12-i interposed between each input fiber 11-i and the bridge fiber 13 collimate a beam (change a divergence angle of the beam to 0°) that has entered the GI fiber 12-i from the input fiber 11-i. This allows a beam bundle that has entered the bridge fiber 13 from the GI fiber bundle 12 to reach the exit end surface of the bridge fiber 13 without an increase in the divergence angle while propagating through the bridge fiber 13. As a result, a plurality of beams constituting the beam bundle are even less likely to be reflected by the core-cladding boundary of the bridge fiber 13, and propagation angles of the plurality of beams constituting the beam bundle are even less likely to be increased while the plurality of beams propagate the bridge fiber 13. This makes it even less likely that combined light entering the output fiber 14 from the bridge fiber 13 includes a high NA component.

Note that in order for a beam that has entered the GI fiber 12-i from the input fiber 11-i to be collimated, the length L0 of the GI fiber 12-i may be set to k×P0/4 (k is any odd number) in a case where the beam is collected to the vicinity of a center of the entrance end surface of the GI fiber 12-i. P0 is the pitch length of GI fiber 12-i.

The combiner 1 in accordance with Embodiment 1 employs both (1) a configuration in which a beam that has entered the GI fiber 12-i from the input fiber 11-i is collimated by the GI fiber 12-i and (2) a configuration in which a beam bundle is converged by the GI fiber section 131 of the bridge fiber 13 so that a plurality of beams that have entered the bridge fiber 13 from the GI fiber bundle 12 intersect with one another at the center of the exit end surface of the bridge fiber 13. This allows the plurality of beams constituting the beam bundle to reach the center of the exit end surface of the bridge fiber 13 without being reflected by the core-cladding boundary of the bridge fiber 13. In this case, an incident angle at which each of the plurality of beams constituting the beam bundle enters the output fiber 14 from the bridge fiber 13 is smaller than tan⁻¹((D/2)/L2). D is a diameter of a circle circumscribing an outer circumference of a cross section of an input fiber located farthest from the center of the bridge fiber 13, to which the input fibers 11-1 through 11-7 are connected, among the input fibers 11-1 through 11-7, wherein a center of the circle coincides with a center position of an input fiber 11-1 (GI fiber 12-1) connected to a position that at least overlaps with a portion of the vicinity of the center of the GI fiber section 131. L2 is the length of the SI fiber section 132 of the bridge fiber 13. Note that "the vicinity of the center of the GI fiber section 131" includes (i) a center position of the GI fiber section 131 and (ii) a position that is located off the center position of the GI fiber section 131 by a value of ±5% or less of D/2. For example, in a case where D/2 = 0.2 mm and L2 = 40 mm, an incident angle at which each of the plurality of beams constituting the beam bundle enters the output fiber 14 from the bridge fiber 13 is smaller than tan⁻¹(0.2/40) ≈ 0.3°. In a case where the refractive index ≈ 1.45, the incident angle 0.3° corresponds to NA = 1.45·sin(0.3°) ≈ 0.007, which is sufficiently smaller than a NA of a typical SI fiber. In this case, by providing the output fiber 14 as a SI fiber having a maximum value of more than tan⁻¹((D/2)/L2) for an incident angle at which light can be received by (confined in) the SI fiber, it is possible to cause a beam that has entered the output fiber 14 from the bridge fiber 13 to be entirely confined within the core 14a of the output fiber 14.

### Embodiment 2

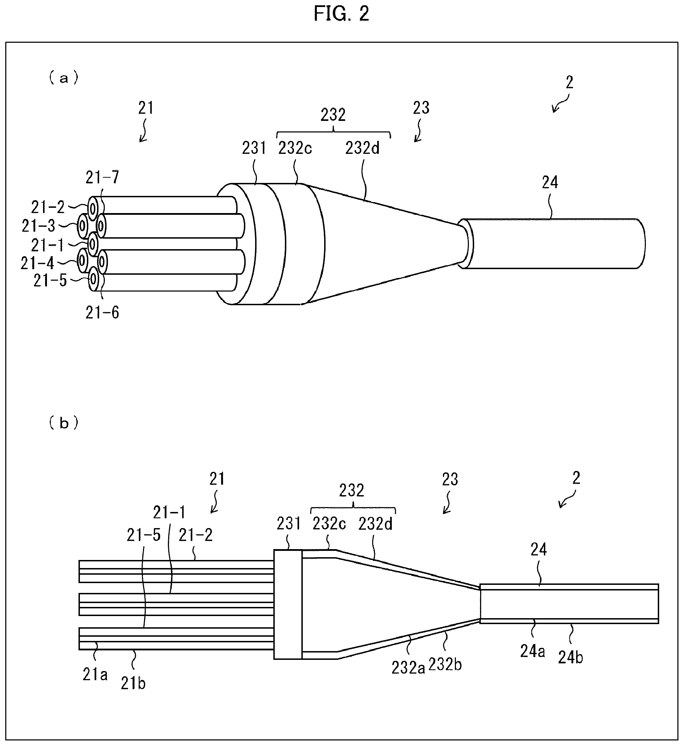

The following description will discuss, with reference to Fig. 2, a configuration of a combiner 2 in accordance with Embodiment 2 of the present invention. In Fig. 2, (a) is a perspective view of the combiner 2 and (b) is a cross-sectional view of the combiner 2.

The combiner 2 is an optical component for generating combined light by combining light beams outputted from respective ones of a plurality of light sources (not illustrated). As illustrated in Fig. 2, the combiner 2 includes an input fiber bundle 21, a bridge fiber 23, and an output fiber 24.

The difference between the combiner 1 in accordance with Embodiment 1 and the combiner 2 in accordance with Embodiment 2 is as follows. That is, the combiner 1 in accordance with Embodiment 1 is arranged such that each input fiber 11-i constituting the input fiber bundle 11 is connected to the entrance end surface of the bridge fiber 13 via the GI fiber 12-i, whereas the combiner 2 in accordance with Embodiment 2 is arranged such that each input fiber 21-i constituting the input fiber bundle 21 is connected directly (not via the GI fiber 12-i) to an entrance end surface of the bridge fiber 23.

The combiner 2 is arranged in the same manner as the combiner 1 in accordance with Embodiment 1 except for the above difference. That is, the input fiber bundle 21, the bridge fiber 23, and the output fiber 24 included in the combiner 2 are arranged in the same manner as the input fiber bundle 11, the bridge fiber 13, and the output fiber 14 included in the combiner 1 in accordance with Embodiment 1, respectively.

Also in the combiner 2 in accordance with Embodiment 2, the bridge fiber 23 includes a GI fiber section 231 which converges a beam bundle that has entered the bridge fiber 23 from the input fiber bundle 21. This makes it less likely that a plurality of beams constituting the beam bundle are reflected by a core-cladding boundary of the bridge fiber 23. As a result, propagation angles of the plurality of beams constituting the beam bundle are less likely to be increased while the plurality of beams propagate the bridge fiber 23. This makes it less likely that combined light entering the output fiber 24 from the bridge fiber 23 includes a high NA component. That is, according to Embodiment 2, it is possible to provide the combiner 2 which is superior in low-loss property and reliability as compared with a case in which the bridge fiber 23 does not include the GI fiber section 231.

### Examples of Application

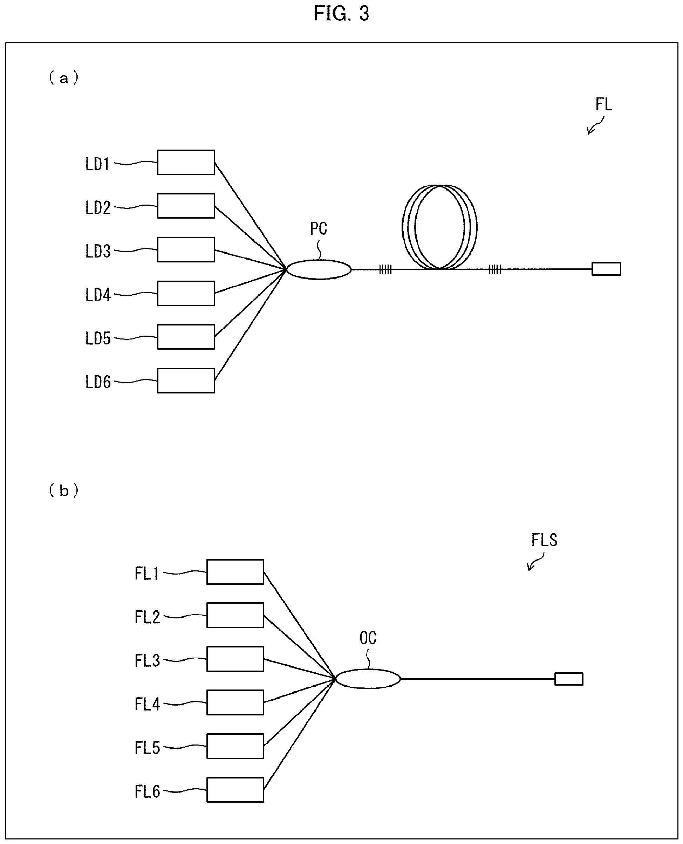

The combiners 1 and 2 in accordance with Embodiments 1 and 2 described above can each be used in various laser devices. For example, in a case where a fiber laser FL including a plurality of laser diodes LD 1 through LD6 illustrated in (a) of Fig. 3 is used as a laser device, the combiners 1 and 2 in accordance with Embodiments 1 and 2 described above can each be used as a pump combiner PC for combining, for use as excitation light, laser light beams outputted from respective ones of the plurality of laser diodes LD 1 through LD6. Further, in a fiber laser system FLS including a plurality of fiber lasers FL1 through FL6 illustrated in (b) of Fig. 3, the combiners 1 and 2 in accordance with Embodiments 1 and 2 described above can each be used as an output combiner OC for combining, for use as output light, laser light beams outputted from respective ones of the plurality of fiber lasers FL1 through FL6.

Aspects of the present invention can also be expressed as follows:
A combiner in accordance with an embodiment of the present invention is a combiner, including: an input fiber bundle consisting of a plurality of input fibers; and a bridge fiber including a GI fiber section which a beam bundle emitted from the input fiber bundle enters, the bridge fiber having a diameter which is smaller at an exit end surface of the bridge fiber than at an entrance end surface of the bridge fiber, the GI fiber section converging the beam bundle emitted from the input fiber bundle.

The combiner in accordance with an embodiment of the present invention is preferably configured such that the GI fiber section converges the beam bundle so that a plurality of beams emitted from the input fiber bundle intersect with each other at a center of the exit end surface of the bridge fiber or in the vicinity of the center. Further, the combiner in accordance with an embodiment of the present invention is preferably configured such that the combiner further includes an output fiber which the beam bundle emitted from the bridge fiber enters, the GI fiber section converging the beam bundle so that a plurality of beams emitted from the input fiber bundle intersect with each other at a center of an entrance end surface of the output fiber or in the vicinity of the center.

The combiner in accordance with an embodiment of the present invention is preferably configured such that: the output fiber includes a core and a cladding covering an outer circumferential surface of the core; and a portion of the core of the output fiber which portion is at the entrance end surface of the output fiber and a portion of a core of the bridge fiber which portion is at the exit end surface of the bridge fiber are at least fusion-spliced to each other.

The combiner in accordance with an embodiment of the present invention is preferably configured such that: the bridge fiber further includes a SI fiber section whose entrance end surface is connected to an exit end surface of the GI fiber section; the SI fiber section includes a reduced diameter part in which a core diameter of the SI fiber section gradually decreases toward an exit end surface of the SI fiber section; and the beam bundle converged by the GI fiber section propagates a core of the SI fiber section.

The combiner in accordance with an embodiment of the present invention is preferably configured such that the exit end surface of the GI fiber section and the entrance end surface of the SI fiber section are fusion-spliced to each other.

The combiner in accordance with an embodiment of the present invention is preferably configured such that the combiner further includes a GI fiber interposed between at least one input fiber included in the input fiber bundle and the bridge fiber, the GI fiber reducing a divergence angle of a beam emitted from the at least one input fiber.

The combiner in accordance with an embodiment of the present invention is preferably configured such that the GI fiber collimates the beam emitted from the at least one input fiber.

The combiner in accordance with an embodiment of the present invention is preferably configured such that: the bridge fiber further includes a SI fiber section whose entrance end surface is connected to an exit end surface of the GI fiber section; the SI fiber section includes a reduced diameter part in which a core diameter of the SI fiber section gradually decreases toward an exit end surface of the SI fiber section; the beam bundle converged by the GI fiber section propagates a core of the SI fiber section; and a maximum value of an incident angle at which the output fiber is capable of receiving light is more than tan⁻¹((D/2)/L), D being a diameter of a circle circumscribing an outer circumference of a cross section of an input fiber located farthest from a center of the bridge fiber, wherein a center of the circle coincides with a center position of an input fiber connected to a position that at least overlaps with a portion of the vicinity of a center of the GI fiber section, L (corresponding to "L2" in Description of Embodiments) being a length of the SI fiber section of the bridge fiber.

The combiner in accordance with an embodiment of the present invention is preferably configured such that the combiner further includes an output fiber which the beam bundle emitted from the bridge fiber enters, the bridge fiber further including a SI fiber section whose entrance end surface is connected to an exit end surface of the GI fiber section, the SI fiber section including a reduced diameter part in which a core diameter of the SI fiber section gradually decreases toward an exit end surface of the SI fiber section, the beam bundle converged by the GI fiber section propagating a core of the SI fiber section, a maximum value of an incident angle at which the output fiber is capable of receiving light being more than tan⁻¹((D/2)/L), D being a diameter of a circle circumscribing an outer circumference of a cross section of an input fiber located farthest from a center of the bridge fiber, wherein a center of the circle coincides with a center position of an input fiber connected to a position that at least overlaps with a portion of the vicinity of a center of the GI fiber section, L (corresponding to "L2" in Description of Embodiments) being a length of the SI fiber section of the bridge fiber.

The combiner in accordance with an embodiment of the present invention is preferably configured such that (i) another optical fiber is fusion-spliced to the exit end surface of the bridge fiber or (ii) the exit end surface of the bridge fiber is flat.

The scope of an embodiment of the present invention also encompasses a laser device, including: the combiner; and a plurality of laser light sources, the combiner combining laser light beams outputted from the plurality of laser light sources. Examples of the laser device encompass (1) a fiber laser that includes the combiner (pump combiner) and a plurality of laser diodes and causes the combiner to combine laser light beams which have been outputted from the plurality of laser diodes and are to be used as excitation light or (2) a fiber laser system that includes the combiner (output combiner) and a plurality of fiber lasers and causes the combiner to combine laser light beams which have been outputted from the plurality of fiber lasers and are to be used as output light.

### Supplementary Note

The present invention is not limited to the description of the embodiments above, but may be altered as appropriate by a skilled person within the scope of the claims. That is, the present invention encompasses an embodiment based on a proper combination of technical means modified as appropriate within the scope of the claims.

**Reference Signs List**

| | | | |
|---|---|---|---|
| 1 | combiner (Embodiment 1) | | |
| 11 | input fiber bundle | | |
| 11-1 | through | 11-7 | input fiber |
| 12 | GI fiber bundle | | |
| 12-1 | through | 12-7 | GI fiber |
| 13 | bridge fiber | | |
| 131 | GI fiber section | | |
| 132 | SI fiber section | | |
| 14 | output fiber | | |
| 2 | combiner (Embodiment 2) | | |
| 21 | input fiber bundle | | |
| 21-1 | through | 21-7 | input fiber |
| 23 | bridge fiber | | |
| 231 | GI fiber section | | |
| 232 | SI fiber section | | |
| 24 | output fiber | | |

## Claims

1. A combiner, comprising:
an input fiber bundle consisting of a plurality of input fibers; and
a bridge fiber including a GI fiber section which a beam bundle emitted from the input fiber bundle enters, the bridge fiber having a diameter which is smaller at an exit end surface of the bridge fiber than at an entrance end surface of the bridge fiber,
the GI fiber section converging the beam bundle emitted from the input fiber bundle.

2. The combiner as set forth in claim 1, wherein the GI fiber section converges the beam bundle so that a plurality of beams emitted from the input fiber bundle intersect with each other at a center of the exit end surface of the bridge fiber or in the vicinity of the center.

3. The combiner as set forth in claim 1, further comprising an output fiber which the beam bundle emitted from the bridge fiber enters,
the GI fiber section converging the beam bundle so that a plurality of beams emitted from the input fiber bundle intersect with each other at a center of an entrance end surface of the output fiber or in the vicinity of the center.

4. The combiner as set forth in claim 3, wherein:
the output fiber includes a core and a cladding covering an outer circumferential surface of the core; and
a portion of the core of the output fiber which portion is at the entrance end surface of the output fiber and a portion of a core of the bridge fiber which portion is at the exit end surface of the bridge fiber are at least fusion-spliced to each other.

5. The combiner as set forth in any one of claims 1 through 4, wherein:
the bridge fiber further includes a SI fiber section whose entrance end surface is connected to an exit end surface of the GI fiber section;
the SI fiber section includes a reduced diameter part in which a core diameter of the SI fiber section gradually decreases toward an exit end surface of the SI fiber section; and
the beam bundle converged by the GI fiber section propagates a core of the SI fiber section.

6. The combiner as set forth in claim 5, wherein the exit end surface of the GI fiber section and the entrance end surface of the SI fiber section are fusion-spliced to each other.

7. The combiner as set forth in any one of claims 1 through 6, further comprising a GI fiber interposed between at least one input fiber included in the input fiber bundle and the bridge fiber, the GI fiber reducing a divergence angle of a beam emitted from the at least one input fiber.

8. The combiner as set forth in claim 7, wherein the GI fiber collimates the beam emitted from the at least one input fiber.

9. The combiner as set forth in claim 3 or 4, wherein:
the bridge fiber further includes a SI fiber section whose entrance end surface is connected to an exit end surface of the GI fiber section;
the SI fiber section includes a reduced diameter part in which a core diameter of the SI fiber section gradually decreases toward an exit end surface of the SI fiber section;
the beam bundle converged by the GI fiber section propagates a core of the SI fiber section; and
a maximum value of an incident angle at which the output fiber is capable of receiving light is more than tan⁻¹((D/2)/L), D being a diameter of a circle circumscribing an outer circumference of a cross section of an input fiber located farthest from a center of the bridge fiber among the plurality of input fibers constituting the input fiber bundle, wherein a center of the circle coincides with a center position of an input fiber connected to a position that at least overlaps with a portion of the vicinity of a center of the GI fiber section, L being a length of the SI fiber section of the bridge fiber.

10. The combiner as set forth in claim 1 or 2, further comprising an output fiber which the beam bundle emitted from the bridge fiber enters,
the bridge fiber further including a SI fiber section whose entrance end surface is connected to an exit end surface of the GI fiber section,
the SI fiber section including a reduced diameter part in which a core diameter of the SI fiber section gradually decreases toward an exit end surface of the SI fiber section,
the beam bundle converged by the GI fiber section propagating a core of the SI fiber section,
a maximum value of an incident angle at which the output fiber is capable of receiving light being more than tan⁻¹((D/2)/L), D being a diameter of a circle circumscribing an outer circumference of a cross section of an input fiber located farthest from a center of the bridge fiber among the plurality of input fibers constituting the input fiber bundle, wherein a center of the circle coincides with a center position of an input fiber connected to a position that at least overlaps with a portion of the vicinity of a center of the GI fiber section, L being a length of the SI fiber section of the bridge fiber.

11. The combiner as set forth in any one of claims 1 through 10, wherein (i) another optical fiber is fusion-spliced to the exit end surface of the bridge fiber or (ii) the exit end surface of the bridge fiber is flat.

12. A laser device, comprising:
a combiner recited in any one of claims 1 through 11; and
a plurality of laser light sources,
the combiner combining laser light beams outputted from the plurality of laser light sources.
